(19) Europäisches Patentamt
European Patent Office
Office européen des brevets

(11) Veröffentlichungsnummer: **0 490 161 A2**

(12) # EUROPÄISCHE PATENTANMELDUNG

(21) Anmeldenummer: **91120124.2**

(51) Int. Cl.5: **C23F 11/14**, C23F 11/16

(22) Anmeldetag: **26.11.91**

(30) Priorität: **08.12.90 DE 4039271**

(43) Veröffentlichungstag der Anmeldung:
**17.06.92 Patentblatt 92/25**

(84) Benannte Vertragsstaaten:
**DE FR GB IT**

(71) Anmelder: **BASF Aktiengesellschaft**
**Carl-Bosch-Strasse 38**
**W-6700 Ludwigshafen(DE)**

(72) Erfinder: **Tschang, Chung-Ji, Dr.**
**Hinterbergstrasse 31**
**W-6702 Bad Duerkheim(DE)**
Erfinder: **Reif, Wolfgang, Dr.**
**Ernst-Ludwig-Kirchner-Strasse 2**
**W-6710 Frankenthal(DE)**
Erfinder: **Ebel, Klaus, Dr.**
**Asternstrasse 14**
**W-6704 Mutterstadt(DE)**

(54) **Verfahren zum Schutz von Kupfer- und Kupferlegierungsoberflächen vor Korrosion.**

(57) Verfahren zum Schutz von Kupfer- und Kupferlegierungsoberflächen vor Korrosion unter dem Einfluß der Atmosphäre, indem man die Metalloberflächen mit einer Lösung einer oder mehrerer heterocyclischer Verbindungen der allgemeinen Formel I

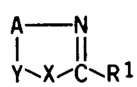

I

in der

$R^1$ Wasserstoff, eine $C_1$- bis $C_{18}$-Alkylgruppe, eine gegebenenfalls am aromatischen Kern durch eine $C_1$- bis $C_8$-Alkylgruppe substituierte Benzylgruppe, einen gegebenenfalls durch eine $C_1$- bis $C_8$-Alkylgruppe substituierten Phenylrest oder eine Aminogruppe bezeichnet,

X für NH oder S steht und

A und Y

a) zusammen eine 1,2- oder 2,3-Alkylengruppierung aus 2 bis 4 C-Atomen oder

b) zusammen einen 1,2-Phenylenrest bedeuten oder

c) A für $C\text{-}NH_2$ und Y für N steht,

wobei die Bindung zwischen A und Y in den Fällen b) und c) eine Doppelbindung ist,

in Kontakt bringt, gegebenenfalls nachspült und anschließend trocknet.

EP 0 490 161 A2

Die vorliegende Erfindung betrifft ein neues Verfahren zum Schutz von Kupfer- und Kupferlegierungsoberflächen vor Korrosion unter dem Einfluß der Atmosphäre.

Die Korrosion, d.h. Oxidation, unter dem Einfluß der Atmosphäre beeinträchtigt das Aussehen kupferner Gegenstände sowie die Lötbarkeit des Kupfers, was auf dem Gebiet der Elektronik und hier besonders bei Leiterplatten ein großes Problem darstellt.

Üblicherweise werden freiliegende Kupferflächen auf Leiterplatten überwiegend durch Heißverzinnung oder durch galvanische Abscheidung von Zinn oder einer Blei/Zinn-Legierung vor Oxidation geschützt und somit lötfähig erhalten. Im Anschluß an die galvanische Abscheidung ist in der Regel ein Umschmelzprozeß erforderlich.

Zur Vermeidung dieser technisch aufwendigen und deshalb kostspieligen Heißverzinnungs- und Abscheidungsprozesse wurden einfachere Verfahren vorgeschlagen, die der temporären Erhaltung der Lötbarkeit von freiliegenden Kupferflächen auf Leiterplatten dienen. Diese Verfahren sehen die Behandlung von Kupferoberflächen mit wäßrigen Lösungen vor, die bestimmte korrosionsinhibierende Wirkstoffe enthalten.

So betrifft die DE-B 20 03 175 (1) die Verwendung von 2-Alkylimidazolen der Formel II

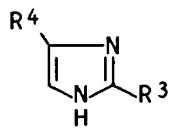

II

in der $R^3$ für eine lange geradkettige Alkylgruppe mit 5 bis 21 C-Atomen und $R^4$ für Wasserstoff oder eine niedere Alkylgruppe steht, oder deren Säureadditionssalzen als Korrosionsschutzmittel für vor korrodierend wirkender Atmosphäre zu schützende Kupfer- und Kupferlegierungsoberflächen.

Die EP-A 178 864 (2) betrifft ein Verfahren zur Herstellung von Leiterplatten unter Mitverwendung von wäßrigen Lösungen der Säureadditionssalze der 2-Alkylimidazole II.

Der Nachteil bei der Verwendung der Verbindungen II liegt in der geringen Temperaturstabilität der hiermit erzeugten Schutzschichten. Wenn eine mit einem solchen Schutz ausgerüstete Leiterplatte zur Härtung des Klebers von oberflächenmontierbaren Bauteilen erwärmt wird oder in zwei Lötschritten bestückt werden soll, wird die Schutzschicht zerstört, wobei die Produkte des thermischen Abbaus die nachfolgende Lötung beeinträchtigen oder verhindern.

Der vorliegenden Erfindung lag daher die Aufgabe zugrunde, ein Verfahren zu finden, in welchem durch Behandlung mit der Lösung eines geeigneten Wirkstoffs ein Korrosionsschutz für Kupfer- und Kupferlegierungsoberflächen erzeugt wird, wobei die erzeugte Schutzschicht temperaturstabil ist und nach einer thermischen Belastung eine Lötung auf einer solchen Oberfläche möglichst wenig behindert wird.

Demgemäß wurde ein Verfahren zum Schutz von Kupfer- und Kupferlegierungsoberflächen vor Korrosion unter dem Einfluß der Atmosphäre gefunden, welches dadurch gekennzeichnet ist, daß man die Metalloberflächen mit einer Lösung einer oder mehrerer heterocyclischer Verbindungen der allgemeinen Formel I

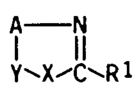

I

in der

- $R^1$ Wasserstoff, eine $C_1$- bis $C_{18}$-Alkylgruppe, eine gegebenenfalls am aromatischen Kern durch eine $C_1$- bis $C_8$-Alkylgruppe substituierte Benzylgruppe, einen gegebenenfalls durch eine $C_1$- bis $C_8$-Alkylgruppe substituierten Phenylrest oder eine Aminogruppe bezeichnet,
- X für NH oder S steht und
- A und Y
  - a) zusammen eine 1,2- oder 2,3-Alkylengruppierung aus 2 bis 4 C-Atomen oder
  - b) zusammen einen 1,2-Phenylenrest bedeuten oder
  - c) A für $C\text{-}NH_2$ und Y für N steht,

  wobei die Bindung zwischen A und Y in den Fällen b) und c) eine Doppelbindung ist,

in Kontakt bringt, gegebenenfalls nachspült und anschließend trocknet.

Für den Rest $R^1$ kommen neben Wasserstoff und der Aminogruppe

- eine $C_1$- bis $C_{18}$-Alkylgruppe, insbesondere eine $C_1$- bis C..-Alkylgruppe, wie Methyl, Ethyl, n-Propyl, iso-Propyl, n-Butyl, iso-Butyl, sec.-Butyl, tert.-Butyl, n-Pentyl, n-Hexyl, n-Heptyl, n-Octyl, 2-Ethylhexyl, n-Nonyl, iso-Nonyl, n-Decyl, n-Undecyl, n-Dodecyl, n-Tridecyl, iso-Tridecyl, n-Tetradecyl, n-Hexadecyl, n-Heptadecyl oder n-Octadecyl,
- eine Benzylgruppe, welche in o-, m- oder p-Stellung durch eine $C_1$- bis $C_8$-Alkylgruppe, insbesondere eine $C_1$- bis $C_4$-Alkylgruppe, substituiert sein kann, oder - ein Phenylrest, welcher in o-, m- oder p-Stellung durch eine $C_1$- bis $C_8$-Alkylgruppe, insbesondere eine $C_1$- bis $C_4$-Alkylgruppe, substituiert sein kann,

in Betracht.

Die Variable X steht vorzugsweise für NH.

Bedeuten die Variablen A und Y gemäß a) zusammen eine 1,2- oder 2,3-Alkylengruppierung aus 2 bis 4 C-Atomen, z.B. 1,2-Ethylen, 1,2-Propylen, 1,2-Butylen oder 2,3-Butylen, wobei mögliche Methyl- oder Ethylseitenketten im 2-Imidazolin-Ring in 4- oder 5-Position stehen können, zeigen Verbindungen 1 mit einer 1,2-Ethylengruppierung eine besonders gute Wirkung.

In einer bevorzugten Ausführungsform werden als heterocyclische Verbindungen I in 2-Stellung substituierte 2-Imidazoline der allgemeinen Formel Ia, 2-Aminobenzimidazol der Formel Ib und/oder 3-Amino-1,2,4-triazol der Formel Ic

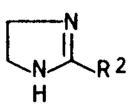
Ia

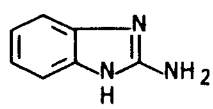
Ib

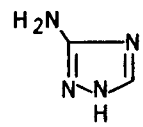
Ic

verwendet. Der Rest $R^2$ hat hierbei die gleiche Bedeutung wie $R^1$ mit Ausnahme von Wasserstoff und der Aminogruppe. Besonders bevorzugt wird von den Verbindungen Ia 2-Phenyl-2-imidazolin.

Als Lösungsmittel für die heterocyclischen Verbindungen I eignen sich Wasser oder mit Wasser mischbare organische Lösungsmittel, vor allem Alkohole, z.B. Methanol, Ethanol, iso-Propanol oder n-Propanol, Ether, z.B. Tetrahydrofuran, oder Ketone, z.B. Aceton oder Butanon, daneben aber auch Carbonsäureester, z.B. Milchsäureethylester, oder Mischungen hieraus, z.B. Wasser-Ethanol, Wasser-Aceton, Ethanol-Aceton oder Wasser-Ethanol-Aceton. Bevorzugt werden wäßrige Lösungsmittelsysteme, insbesondere Wasser allein, da Wasser in Bezug auf Arbeitssicherheit, speziell Brandgefährdung, Umweltverträglichkeit und Wirtschaftlichkeit die meisten Vorteile bietet.

Zur Verbesserung der Löslichkeit der Verbindungen I in Wasser oder den wäßrigen Lösungsmittelsystemen empfiehlt es sich, die Lösungen unter Zuhilfenahme einer üblichen Mineralsäure, z.B. Schwefelsäure, Salzsäure oder Phosphorsäure, oder einer üblichen organischen Säure wie einer Carbonsäure, z.B. Essigsäure, Propionsäure oder Ameisensäure, oder einer Sulfonsäure, z.B. p-Toluolsulfonsäure, schwach sauer zu stellen. Hierbei werden $C_1$- bis $C_3$-Carbonsäuren bevorzugt. Der pH-Wert der Lösung sollte dabei 3 bis 5 betragen. Die Verbindungen I liegen also in der Lösung teilweise oder vollständig als Säureadditionssalze vor.

Die Applikation der Lösungen von I geschieht dadurch, daß man diese Behandlungslösungen auf eine Temperatur von 15 bis 60 °C, vorzugsweise 15 bis 55 °C, insbesondere 20 bis 40 °C, einstellt und hiermit die Kupfer- und Kupferlegierungsoberflächen für eine Zeit von mindestens 5 sec, vorzugsweise 10 bis 60 sec, insbesondere 15 bis 40 sec, in Kontakt bringt. Das In-Kontakt-Bringen erfolgt am einfachsten durch Tauchen des zu schützenden Gegenstandes in die Lösung, man kann aber auch den Gegenstand mit der Lösung besprühen oder bepinseln.

Zur Vermeidung eines Wirkstoffüberschusses empfiehlt es sich, die Oberfläche des Gegenstandes nach der Behandlung mit dem verwendeten oder einem anderen geeigneten Lösungsmittel, vorzugsweise jedoch mit einem wasserhaltigen Lösungsmittel, insbesondere mit reinem Wasser, nachzuspülen. Hierbei ist darauf zu achten, daß das zum Nachspülen verwendete Wasser bzw. wasserhaltige Lösungsmittel keinen pH-Wert, der kleiner als 6 ist, aufweist, da sonst der Wirkstoff, der in einer dünnen Schicht die Metalloberfläche bedeckt, wieder abgelöst und die Schutzschicht zerstört wird. Das Nachspülen geschieht beispielsweise durch Eintauchen des Gegenstandes in Wasser oder durch überleitung von Wasser über die Oberfläche des Gegenstandes. Anschließend wird die Oberfläche des Gegenstandes in üblicher Weise getrocknet, beispielsweise bei Raumtemperatur an der Luft oder im Trockenschrank bei ca. 40 bis 100 °C.

Der Gehalt der Lösungen der Verbindungen I beträgt 0,01 bis 2,5 Gew.-%, vorzugsweise 0,05 bis 1,5

Gew.-%, insbesondere 0,1 bis 0,5 Gew.-%. Bei kleineren Gehalten als 0,01 Gew.-% ist keine Schutzwirkung mehr nachweisbar, bei größeren Gehalten als 2,5 Gew.-% wird eine erhöhte Beeinträchtigung der Lötbarkeit der Metalloberflächen nach einer thermischen Belastung beobachtet.

Die beschriebenen Lösungen eignen sich zum effektiven Korrosionsschutz aller Metalloberflächen, die vor allem aus Kupfer aber auch aus Kupferlegierungen bestehen, so beispielsweise auch von Messingoberflächen. Man kommt zudem beim erfindungsgemäßen Verfahren mit relativ niedrigkonzentrierten Behandlungslösungen aus, wodurch Wirksubstanz eingespart werden kann. Von besonderer Bedeutung ist das erfindungsgemäße Verfahren für die Leiterplattentechnologie. Die auf den Gegenständen mit kupferhaltigen Oberflächen erzeugten Schutzschichten sind temperaturstabil und behindern auch nach einer thermischen Belastung die Lötvorgänge nicht wesentlich.

Beispiele

Eine wäßrige Lösung der Prüfsubstanz, deren chemische Struktur und Konzentration in der Lösung in den folgenden Tabellen jeweils angegeben ist, wurde mit Essigsäure auf einem pH-Wert von 4 bis 4,5 eingestellt.

Gebohrte, kupferkaschierte Leiterplatten-Basismaterialstücke mit einer Größe von ca. 1 x 10 cm wurden 20 sec bei 30 °C in einer Lösung, bestehend aus 25 ml konz. Schwefelsäure, 5 ml 30 gew.-%igem Wasserstoffperoxid, 1 Tropfen 5 gew.-%iger wäßriger Kupfersulfatlösung mit 75 ml Wasser, angeätzt, mit Wasser nachgespült und mit Preßluft getrocknet.

Ein angeätztes Leiterplatten-Basismaterialstück wurde 20 sec bei 30 °C in die oben beschriebene Lösung getaucht, danach ca. 10 sec in Wasser getaucht und nach dem Abtropfen 15 min bei 80 °C getrocknet.

Die so behandelten Leiterplatten-Basismaterialstücke wurden folgenden Prüfungen unterzogen:

Prüfung A (Dampftest)

Das getauchte und getrocknete Basismaterialstück wurde in einem Reagenzglas mit einem Durchmesser von ca. 3 cm und einem Volumen von 100 ml, das ca. 5 ml Wasser und einen Siedestein enthielt und in ein Heizbad mit einer Temperatur von 110 °C eintauchte, mit Hilfe eines Fadens und eines Glasstabs 45 min lang aufgehängt, ohne daß es in das Wasser eintauchte.

Prüfung B (Hitzetest)

Das Basismaterialstück wurde im Anschluß an Prüfung A 15 min im Trockenschrank bei 200 °C gelagert.

Prüfung C (Lötbarkeitstest)

Die Lötbarkeit des kupferkaschierten Basismaterialstücks wurde durch Verzinnung in einer vertikal arbeitenden Heißverzinnungsmaschine geprüft (Lottemperatur: 240 °C; Eintauchzeit: 4 sec; Flußmittel: 85 Gew.-% mit 10 mol Ethylenoxid umgesetztes Glycerin / 0,45 Gew.-% Glutaminsäure-Hydrochlorid/ 1,05 Gew.-% Milchsäure / Wasser ad 100 Gew.-%).

Die Tabelle 1 gibt die erhaltenen Ergebnisse wieder.

Tabelle 1: Erhaltung der Lötfähigkeit von kupferkaschiertem Leiterplatten-Basismaterial

| Beispiel Nr. | Substanz | Konz. [Gew.-%] | Prüfungen | Prüfnote |
|---|---|---|---|---|
| 1 | 2-Aminobenzimidazol | 0,25 | A + C | 2 |
| 2 | 2-Aminobenzimidazol | 0,25 | A + B + C | 3 |
| 3 | 2-Phenyl-2-imidazolin | 0,20 | A + C | 1 - 2 |
| 4 | 2-Phenyl-2-imidazolin | 0,20 | A + B + C | 2 - 3 |
| 5 | 3-Amino-1,2,4-triazol | 0,20 | A + C | 2 |
| 6 | 3-Amino-1,2,4-triazol | 0,20 | A + B + C | 2 - 3 |
| Zum Vergleich: | | | | |
| A | 2-Undecylimidazol | 2,0 | A + C | 2 |
| B | 2-Undecylimidazol | 2,0 | A + B + C | 4 |

Anmerkung: Note 1 = perfekte Verzinnung
Note 2 = leichte Fehler (geringe Entnetzung)
Note 3 = mäßige Fehler (Entnetzung, sehr geringe Nicht-Benetzung)
Note 4 = sehr starke Fehler (nahezu keine Benetzung mit Lot)

Die Wirkung des erfindungsgemäßen Verfahrens kann auch an Leiterplatten selbst gezeigt werden. Hierzu wurden anstelle von kupferkaschiertem Leiterplatten-Basismaterial durchkontaktierte, unverzinnte Leiterplatten verwendet. Diese wurden, wie oben beschrieben, geätzt, getaucht und den Prüfungen A und B unterzogen. Danach wurden die Leiterplatten ohne Bestückung durch eine Wellenlötmaschine geschickt (Lottemperatur: 250 ° C; Transportgeschwindigkeit: 0,9 m/min). Als Flußmittel wurde die 2 gew.-%ige Lösung von Adipinsäure in Isopropanol verwendet.

Die Ergebnisse sind in der Tabelle 2 enthalten.

Tabelle 2: Erhaltung der Lötfähigkeit von nicht verzinnten Leiterplatten

| Beispiel Nr. | Substanz | Konz. [Gew.-%] | Prüfnote |
|---|---|---|---|
| 7 | 2-Phenyl-2-imidazolin | 0,30 | 1 |
| 8 | 2-Phenyl-2-imidazolin | 0,15 | 1 |
| Zum Vergleich: | | | |
| C | 2-Undecylimidazol | 2,0 | 3 - 4 |

Anmerkung: Note 1 = perfekte Lötung; Lot steigt in den Lötaugen empor; SMD-Flächen (Kontaktflächen für oberflächenmontierbare Bauteile) vollständig benetzt

Note 2 = Lötung mit leichten Mängeln; SMD-Flächen mit geringer Entnetzung

Note 3 = Lötung mit Mängeln; Lot steigt nicht in den Lötaugen empor; SMD-Flächen mit deutlicher Entnetzung

Note 4 = stark gestörte Lötung; SMD-Flächen und Lötaugen nur teilweise mit Lot benetzt

## Patentansprüche

1. Verfahren zum Schutz von Kupfer- und Kupferlegierungsoberflächen vor Korrosion unter dem Einfluß der Atmosphäre, dadurch gekennzeichnet, daß man die Metalloberflächen mit einer Lösung einer oder mehrerer heterocyclischer Verbindungen der allgemeinen Formel I

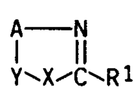

I

in der

$R^1$ Wasserstoff, eine $C_1$- bis $C_{18}$-Alkylgruppe, eine gegebenenfalls am aromatischen Kern durch eine $C_1$- bis $C_8$-Alkylgruppe substituierte Benzylgruppe, einen gegebenenfalls durch eine $C_1$- bis $C_8$-Alkylgruppe substituierten Phenylrest oder eine Aminogruppe bezeichnet,

X für NH oder S steht und

A und Y

a) zusammen eine 1,2- oder 2,3-Alkylengruppierung aus 2 bis 4 C-Atomen oder

b) zusammen einen 1,2-Phenylenrest bedeuten oder

c) A für $C-NH_2$ und Y für N steht,

wobei die Bindung zwischen A und Y in den Fällen b) und c) eine Doppelbindung ist,

in Kontakt bringt, gegebenenfalls nachspült und anschließend trocknet.

2. Verfahren nach Anspruch 1, dadurch gekennzeichnet, daß man als heterocyclische Verbindungen in 2-Stellung substituierte 2-Imidazoline der allgemeinen Formel Ia, 2-Aminobenzimidazol der Formel Ib und/oder 3-Amino-1,2,4-triazol der Formel Ic

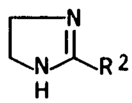

Ia

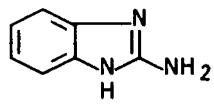

Ib

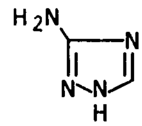

Ic

in der

$R^2$ eine $C_1$- bis $C_{18}$-Alkylgruppe, eine gegebenenfalls durch eine $C_1$- bis $C_8$-Alkylgruppe substituierte Benzylgruppe oder einen gegebenenfalls durch eine $C_1$- bis $C_8$-Alkylgruppe substituierten Phenylrest bezeichnet,

verwendet.

**3.** Verfahren nach Anspruch 1 oder 2, dadurch gekennzeichnet, daß man als Lösungsmittel für die heterocyclischen Verbindungen I Wasser oder mit Wasser mischbare organische Lösungsmittel oder Mischungen hieraus verwendet.

**4.** Verfahren nach den Ansprüchen 1 bis 3, dadurch gekennzeichnet, daß man die Lösungen der heterocyclischen Verbindungen I auf eine Temperatur von 15 bis 60 °C einstellt und hiermit die Metalloberflächen für eine Zeit von mindestens 5 sec in Kontakt bringt.

**5.** Verfahren nach den Ansprüchen 1 bis 4, dadurch gekennzeichnet, daß man Lösungen der heterocyclischen Verbindungen I mit einem Gehalt von 0,01 bis 2,5 Gew.-% verwendet.

**6.** Verwendung von Lösungen einer oder mehrerer heterocyclischer Verbindungen I gemäß Anspruch 1 oder 2 zum Schutz von Kupfer- und Kupferlegierungsoberflächen vor Korrosion unter dem Einfluß der Atmosphäre.